(19) Europäisches Patentamt / European Patent Office / Office européen des brevets

(11) **EP 4 502 999 A1**

(12) **EUROPEAN PATENT APPLICATION**
published in accordance with Art. 153(4) EPC

(43) Date of publication:
**05.02.2025 Bulletin 2025/06**

(21) Application number: **23780343.2**

(22) Date of filing: **27.03.2023**

(51) International Patent Classification (IPC):
**G09F 13/04** (2006.01)    **H10K 59/00** (2023.01)

(52) Cooperative Patent Classification (CPC):
**G09F 13/04; H10K 59/00**

(86) International application number:
**PCT/JP2023/012186**

(87) International publication number:
**WO 2023/190333 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.03.2022 JP 2022051042**

(71) Applicant: **SEKISUI CHEMICAL CO., LTD.**
**Osaka-shi**
**Osaka**
**530-8565 (JP)**

(72) Inventor: **YANAI, Masashi**
**6041LE Roermond (NL)**

(74) Representative: **Ter Meer Steinmeister & Partner**
**Patentanwälte mbB**
**Nymphenburger Straße 4**
**80335 München (DE)**

(54) **LIGHT-EMITTING DISPLAY DEVICE**

(57)    A light-emitting display device 1 of the present invention includes: a base material 10 having a light source 11 mounted thereon; and a foam layer 30 that transmits and diffuses the light from the light source 11 and has at least a portion of the light source 11 embedded therein. According to the present invention, a light-emitting display device that can effectively utilize light from the light source is provided with a simplified component configuration.

Fig. 1

**Description**

Technical Field

The present invention relates to a light-emitting display device.

Background Art

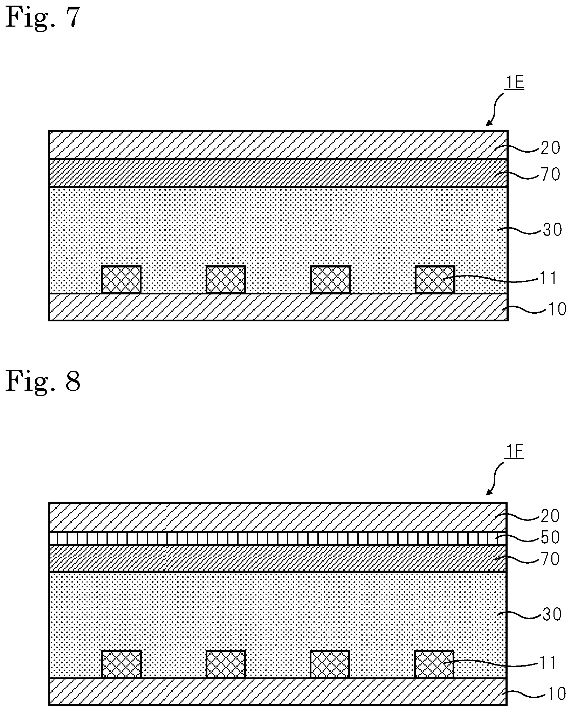

In order to impart a good texture to the surface of interior materials used for vehicles, building furniture, etc., a foam layer is laminated under a skin layer in some cases. Furthermore, in order to create a sense of luxury of the interior materials, the interior materials may be made to emit light or to display information in some cases. For example, in the vehicle interior material described in Patent Literature 1, a light guide section made of a lighttransmittable, hard synthetic resin is provided on light emitting means having a light source such as an LED, a cushion layer made of a foam layer is provided on the light guide section, and a skin material is provided on the cushion layer (refer to Fig. 8). This allows the interior material to emit light while imparting a good texture to the surface of the interior material.

Citation List

Patent Literature

PTL 1: JP 2019-188919 A

Summary of Invention

Technical Problem

However, in the vehicle interior material described in Patent Literature 1, a part of the light from the light source is not used for emission of the interior material, so that the light from the light source cannot be effectively utilized. As a result, the amount of power consumed to cause emission of the vehicle interior material may increase more than necessary in some cases. Furthermore, from the viewpoint of manufacturing costs, it is desirable to further simplify the component configuration of the vehicle interior materials described in Patent Literature 1.

Accordingly, an object of the present invention is to provide a light-emitting display device that can effectively utilize light from a light source, with a simplified component configuration.

Solution to Problem

Through extensive study, the present inventors have found that the problem can be solved by embedding at least a portion of the light source in the foam layer, so that the present invention has been completed.

In other words, the summary of the present invention is described in the following items [1] to [7].

[1] A light-emitting display device comprising: a base material having a light source mounted thereon; and a foam layer that transmits and diffuses light from the light source and has at least a portion of the light source embedded therein.

[2] The light-emitting display device according to item [1], further comprising a skin layer that transmits light from the light source, wherein the foam layer is provided between the skin layer and the base material.

[3] The light-emitting display device according to item [2], further comprising at least one layer of a printed layer and a printed film layer, provided between the skin layer and the foam layer.

[4] The light-emitting display device according to item [3], wherein the printed layer is formed by printing the surface of at least one layer of the foam layer and the skin layer.

[5] The light-emitting display device according to any one of items [2] to [4], further comprising a transparent conductive layer provided between the skin layer and the base material.

[6] The light-emitting display device according to any one of items [2] to [5], further comprising a light control layer provided between the skin layer and the base material.

[7] The light-emitting display device according to any one of items [1] to [6], wherein the base material is a flexible substrate.

[8] The light-emitting display device according to any one of claims [1] to [7], wherein the base material and the foam layer are formed into a three-dimensional shape.

Advantageous Effects of Invention

According to the present invention, a light-emitting display device that can effectively utilize light from a light source can be provided with a simplified component configuration.

Brief Description of Drawings

[Fig. 1] Fig. 1 is a schematic cross-sectional view showing a light-emitting display device in an embodiment of the present invention.
[Fig. 2] Fig. 2 (a) and (b) are diagrams for illustrating embedding of a light source in a foam layer.
[Fig. 3] Fig. 3 is a schematic cross-sectional view showing a modification example of the light-emitting display device in an embodiment of the present invention.
[Fig. 4] Fig. 4 is a schematic cross-sectional view showing a modification example of the light-emitting display device in an embodiment of the present invention.
[Fig. 5] Fig. 5 is a schematic cross-sectional view showing a modification example of the light-emitting display device in an embodiment of the present invention.
[Fig. 6] Fig. 6 is a schematic cross-sectional view showing a modification example of the light-emitting display device in an embodiment of the present invention.
[Fig. 7] Fig. 7 is a schematic cross-sectional view showing a modification example of the light-emitting display device in an embodiment of the present invention.
[Fig. 8] Fig. 8 is a schematic cross-sectional view showing a modification example of the light-emitting display device in an embodiment of the present invention.
[Fig. 9] Fig. 9 is a schematic cross-sectional view showing a modification example of the light-emitting display device in an embodiment of the present invention.

Description of Embodiments

<Light-emitting display device>

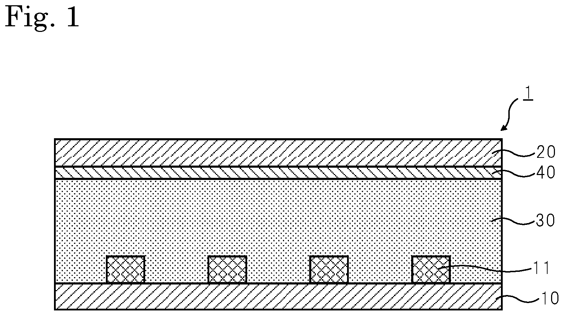

A light-emitting display device in an embodiment of the present invention will be described with reference to Fig. 1. Fig. 1 is a schematic cross-sectional view showing a light-emitting display device in an embodiment of the present invention. As shown in Fig. 1, a light-emitting display device 1 in an embodiment of the present invention includes a base material 10, a skin layer 20, a foam layer 30, and at least one layer 40 of a printed layer and a printed film layer. The base material 10 has a light source 11 mounted thereon, and the skin layer 20 transmits the light from the light source 11. The foam layer 30 that transmits and diffuses the light from the light source 11 is provided between the skin layer 20 and the base material 10, and at least a portion of the light source 11 is embedded in the foam layer 30. The at least one layer 40 of a printed layer and a printed film layer is provided between the skin layer 20 and the foam layer 30. In the light-emitting display device 1 in an embodiment of the present invention, at least a portion of the light source 11 is embedded in the foam layer 30, so the foam layer 30 diffuses much of the light generated from the light source 11, and guides the light to the outside. As a result, the foam layer 30 can effectively utilize much of the light generated from the light source 11 as light that causes emission of the light-emitting display device 1. Further, in the light-emitting display device 1 in an embodiment of the present invention, there is no need to separately provide a diffusion member, a light guide member, etc. As a result, the light-emitting display device 1 can have a simplified component configuration with a smaller thickness. Furthermore, by using the flexible foam layer 30, it is possible to absorb the unevenness of components such as the light source 11 on the base material 10, so that the light-emitting display device 1 can have a smooth surface, and can easily have a soft feel.

[Light source]

The light source 11 may be any light source used for lighting devices such as a fluorescent lamp, an incandescent lamp, an LED, and an organic EL element. Among these, an LED and an organic EL element are preferred, and an LED is more preferred. The LED is also referred to as a light emitting diode.
The LED includes, for example, an LED chip, which works as a point light source with a bright spot. Although an LED as a point light source with a bright spot has high straightness of light, the foam layer 30 illuminated by an LED chip with a point light source allows the light generated from the light source to be appropriately diffused. Further, since the point light source has a small thickness, the light-emitting display device may be thinned.
The shape of LED is not particularly limited, and may be a rectangle or any other shape. Further, the size of the LED is not particularly limited, and for example, the area thereof may be about 5 cm$^2$ or less, about 1 cm$^2$ or less, or about 0.1 cm$^2$ or less, and may be, for example, 0.001 cm$^2$ or more, or 0.005 cm$^2$ or more.

Further, the light source 11 may be a plurality of light-emitting elements arranged side by side, and may be, for example, a plurality of LEDs arranged side by side. Specifically, for example, the light-emitting elements may be arranged in a line, or may be arranged in any form such as a grid pattern or a staggered pattern.

[Base material]

The base material 10 that supports the light source 11 is not particularly limited as long as it is a base material on which the light source can be mounted. Examples of the base material 10 include various types of substrates such as a printed circuit board, which may be a rigid substrate or a flexible substrate. Examples of the rigid substrate include a paper base material-including phenol resin substrate and a glass cloth base material-including epoxy resin substrate. The flexible substrate is preferably a resin film such as polyimide film, polyester film and polycarbonate film, though may be made of other materials.

The base material 10 is preferably a flexible substrate in the case where the light-emitting display device 1 is installed so as to follow the curved surface of a vehicle, building furniture, etc. Further, a flexible substrate as the base material 10 allows the light-emitting display device 10 to be thinner. Alternatively, the base material and the foam layer may be formed into a three-dimensional shape. For example, use of a moldable base material such as polycarbonate film as the base material 10 allows a three-dimensional shape to be formed, so that functional designability can be improved. For example, molding the foam layer together with the base material 10 into a desired three-dimensional shape allows man-hours required for molding the foam layer and the base material 10 into a three-dimensional shape to be reduced.

What is mounted on the base material 10 is not limited to the light source 11. For example, various electric circuits of a control device for controlling a light source may be mounted on the base material. Electric circuits other than the light source may also be embedded in the foam layer 30 together with the light source.

<Foam layer>

The foam layer 30 that transmits and diffuses the light from the light source 11 is provided between the skin layer 20 and the base material 10, and at least a portion of the light source 11 is embedded in the foam layer 30.

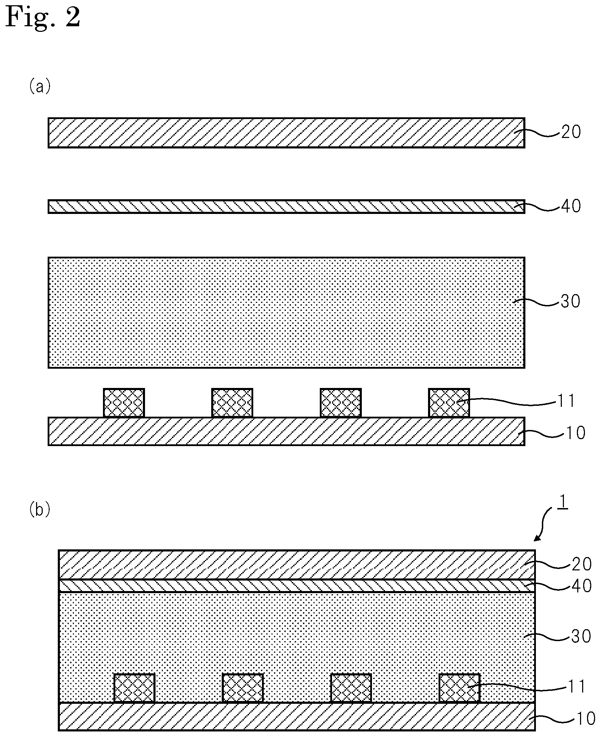

Due to internally containing cells, the foam layer 30 easily ensures flexibility and is easily deformed. Therefore, the foam layer 30 can provide an excellent texture to the light-emitting display device 1, and allows at least a portion of the light source to be embedded therein. For example, as shown in Fig. 2 (a), even in the case where the foam layer 30 is not shaped to fit the light source 11, the foam layer 30 having flexibility is dented by compressive deformation at a portion where the light source 11 is provided, so that the light source 11 is embedded in the foam layer 30 as shown in Fig. 2 (b). Moreover, due to containing cells therein, the foam layer 30 can transmit and diffuse the light from the light source 11. Since the light source 11 is embedded in the foam layer 30, much of the light generated by the light source 11 can be diffused by the cells of the foam layer 30. Alternatively, the foam layer 30 for use may be formed into a shape that fits the light source 11 in advance. Ones having a portion overlapping with the light source 11 dented by compressive deformation in advance, or bored by cutting, dissolving or the like, may be used. Further, the foam layer 11 may be provided with a groove extending from a spot overlapping with the light source 11 to another spot. Thereby, heat from the light source 11 may be released to the other spot.

The thickness of the foam layer 30 is preferably 0.1 to 5 mm, more preferably 0.5 to 4 mm, and still more preferably 0.6 to 3.5 mm. With a thickness of the foam layer 30 in the range, the foam layer 30 can easily diffuse the light from the light source 11, and the light from the light source 11 can be easily irradiated to the outside through the skin layer 20.

(Total light transmittance)

The foam layer 30 has a total light transmittance of preferably 10% or more. With a total light transmittance of 10% or more, the foam layer 30 can have sufficient light transparency, so that the light starting from the light source 11 is easily emitted to the outside at a certain light intensity or more. The foam layer 30 has a total light transmittance of more preferably 20% or more, and still more preferably 30% or more. The higher the total light transmittance of the foam layer 30, the better. However, from the viewpoint of enhancing the light diffusibility, the total light transmittance is, for example, 95% or less, preferably 90% or less, and still more preferably 85% or less. The total light transmittance may be controlled in the range by appropriately controlling the expansion ratio, the resin components, and the type of additives compounded in the resin such as pigments and dyes.

<25% Compressive strength>

It is preferable that the 25% compressive strength of the foam layer 30 be 10 to 2500 kPa. With a 25% compressive strength equal to or less than the upper limit, the foam layer 30 has improved flexibility, so that the texture of the surface of the light-emitting display device 1 is further improved, and at least a part of the light source is more easily embedded therein. On the other hand, with a 25% compressive strength equal to or more than the lower limit, good mechanical strength of the foam layer 30 can be achieved. From these viewpoints, the 25% compressive strength of the foam layer 30 is more preferably 30 to 2000 kPa, more preferably 50 to 1500 kPa, and most preferably 80 to 900 kPa.
The 25% compressive strength is a value measured by the measurement method in accordance with JIS K6767.

<Expansion ratio>

The expansion ratio of the foam layer 30 is not particularly limited, and preferably 7 to 40. With an expansion ratio equal to or more than 7, foaming of the foam constituting the foam layer 30 is moderate, so that improved light transparency and light diffusibility are achieved together with improved flexibility. With an expansion ratio of the foam layer equal to or less than 40, the mechanical strength of the foam layer 30 can be secured. The expansion ratio of the foam layer 30 is more preferably 10 to 35, and still more preferably 12 to 33. Note that the expansion ratio may be calculated by dividing the density of the foam before foaming by the density (apparent density) of the foam after foaming.
The resin constituting the foam layer 30 is not particularly limited, and various types of resin may be used. Specifically, urethane resins, acrylic resins, polyolefin resins, polystyrene resins, various elastomers, rubbers, etc. may be used, and among these, polyolefin resins are preferred. Use of a polyolefin resin allows appropriate flexibility and mechanical strength to be imparted to a foam sheet. Further, the resin is preferably a thermoplastic resin from the viewpoint of facilitating foaming.
The foam constituting the foam layer 30 may be obtained by foaming an expandable composition containing a resin, preferably by foaming an expandable composition containing at least a polyolefin resin, and more preferably by crosslinking and foaming an expandable composition containing a polyolefin resin.
Examples of the polyolefin resin include polyethylene resins, polypropylene resins, and ethylene-vinyl acetate copolymers. Among these, polyethylene resins are preferred from the viewpoint of flexibility.

<Crosslinking degree (gel fraction)>

The foam constituting the foam layer 30 is preferably a cross-linked one as described above, and the crosslinking degree (gel fraction) thereof is preferably 5 to 60 mass%. With a gel fraction equal to or more than the lower limit, the foam layer tends to have enhanced mechanical strength due to formation of sufficient crosslinking. With a crosslinking degree equal to or less than the upper limit, the foam tends to secure flexible texture. From these viewpoints, the crosslinking degree is more preferably 10 to 50 mass%, still more preferably 20 to 40 mass%. The crosslinking degree may be measured by the measurement method described below.
Hereinafter, a foam made of polyolefin resin as the resin that constitutes the foam layer 30 (polyolefin resin foam) will be described in more detail.

[Polyolefin resin foam]

The polyolefin resin foam is obtained by foaming a polyolefin resin composition containing a polyolefin resin.
It is preferable that the polyolefin resin foam be mainly composed of polyolefin resin. Specifically, the content of the polyolefin resin is preferably 65 mass% or more relative to 100 mass% of the total amount of resin components contained in the polyolefin resin composition. In addition, hereinafter, setting the total amount of resin components contained in the polyolefin resin composition to 100 mass% may simply be referred to as "based on the total amount of resin components." Although polyolefin resin foams made of polyolefin resin as main component generally tend to have a lower light transparency, a polyolefin resin foam having excellent total light transmittance can be obtained in the present invention through appropriate adjustment of the expansion ratio, resin components, compounds added to the resin, etc.

<Polyolefin resin>

As the polyolefin resin, one or more selected from the group consisting of a polyethylene resin, a polypropylene resin, and an ethylene-vinyl acetate copolymer are preferred. One of these resins may be used alone, or two or more thereof may be used in combination.
It is preferable that the polyolefin resin foam of the present invention be mainly composed of polyolefin resin. Specifically, it is preferable that the content of the polyolefin resin be 65 mass% or more based on the total amount of the resin components contained in the polyolefin resin composition. With a content of the polyolefin resin of 65 mass% or more, the mechanical strength, flexibility, etc., of the foam tend to be secured. Also, as described below, the main component resin tends to be easily made of the olefine resin of one type. From these viewpoints, the content of the polyolefin resin is preferably 70 to 100 mass%, more preferably 75 to 100 mass%, based on the total amount of the resin components contained in the foam resin composition.

«Polyethylene resin»

Examples of the polyethylene resin include a low density polyethylene resin ($0.93$ g/cm$^3$ or less, LDPE), a medium density polyethylene resin (more than $0.930$ g/cm$^3$ and less than $0.942$ g/cm$^3$, MDPE), and a high density polyethylene resin ($0.942$ g/cm$^3$ or more, HDPE). Also, preferred specific examples of the low density polyethylene resin include a linear low density polyethylene resin (LLDPE).

In particular, a linear low density polyethylene resin and a high density polyethylene resin are preferred, and a linear low density polyethylene resin (LLDPE) is more preferred. By using these resins, the rate of change of the compressive strength of the foam tends to be easily reduced.

The density of the linear low density polyethylene resin is preferably $0.90$ g/cm$^3$ or more, more preferably $0.91$ g/cm$^3$ or more and $0.93$ g/cm$^3$ or less. Also, the density of the high density polyethylene resin is preferably $0.98$ g/cm$^3$ or less, more preferably $0.95$ g/cm$^3$ or more and $0.97$ g/cm$^3$ or less. With the density of the high density polyethylene resin and the linear low density polyethylene resin controlled in the ranges, the compressive strength tends to be easily reduced without impairment to the flexibility of the foam.

The polyethylene resin may be a homopolymer of ethylene, or may be a copolymer of ethylene as main component (preferably 75 mass% or more, more preferably 90 mass% or more, relative to the all monomers) and a small amount of $\alpha$-olefin. Examples of the $\alpha$-olefin include preferably ones having 3 to 12 carbon atoms, more preferably ones having 4 to 10 carbon atoms, specifically 1-butene, 1-pentene, 1-hexene, 4-methyl-1-pentene, 1-heptene, and 1-octene. These $\alpha$-olefins may be used alone or in combination of two or more thereof to compose the copolymer.

Also, the polyethylene resins may be used alone or in combination of two or more thereof.

«Polypropylene resin»

Examples of the polypropylene resin may include a homopolypropylene that is a homopolymer of propylene, or a copolymer of propylene as main component (preferably 75 mass% or more, more preferably 90 mass% or more, relative to the all monomers) and a small amount of $\alpha$-olefin other than ethylene and propylene.

Examples of the copolymer of propylene and $\alpha$-olefin other than ethylene and propylene include a block copolymer (block polypropylene), a random copolymer (random polypropylene), and a random block copolymer.

Examples of the $\alpha$-olefin other than propylene include an $\alpha$-olefin having about 4 to 10 carbon atoms such as 1-butene, 1-pentene, 1-hexene, 4-methyl-1-pentene, 1-heptene and 1-octene, and in particular, ethylene is preferred from the viewpoints of formability and heat resistance. These $\alpha$-olefins may be used alone or in combination of two or more to compose the copolymer.

Also, the polypropylene resins may be used alone or in combination of two or more.

In the foam constituting the foam layer 30, any one of a polyethylene resin, a polypropylene resin and a mixture thereof polymerized using a polymerization catalyst such as a Ziegler-Natta compound, a metallocene compound and a chromium oxide compound may be used. A foam having high flexibility is easily made from a polyethylene resin, or a linear low density polyethylene in particular, obtained by using a metallocene compound as polymerization catalyst.

«Ethylene-vinyl acetate copolymer»

Examples of the ethylene-vinyl acetate copolymer for use as polyolefin resin include an ethylene-vinyl acetate copolymer containing 50 mass% or more of a constitutional unit derived from ethylene. The ethylene-vinyl acetate copolymer has a high compatibility with a polyethylene resin and a polypropylene resin, so that use of an ethylene-vinyl acetate copolymer and one or more selected from the group consisting of a polyethylene resin and a polypropylene resin in combination improves the light transparency of the foam.

The density of the ethylene-vinyl acetate copolymer is preferably $0.92$ g/cm$^3$ or more, more preferably $0.93$ g/cm$^3$ or more, still more preferably $0.94$ g/cm$^3$ or more, and preferably $0.97$ g/cm$^3$ or less, more preferably $0.96$ g/cm$^3$ or less. With a density of the ethylene-vinyl acetate copolymer controlled in the range, the foam tends to easily have reduced compressive strength without impairing to the flexibility.

In the foam constituting the foam layer 30, it is preferable that the polyolefin resin composition include any one of the polyolefin resins described above as main component resin. The main component resin refers to 65 mass% or more of any one of a resin contained in polyolefin resins based on the total amount of the resin components. Accordingly, it is preferable that 65 mass% or more of any one of a polypropylene resin, a polyethylene resin and an ethylene-vinyl acetate copolymer be contained.

In general, in blending of two or more resins, the resins are not completely mixed each other, resulting in hazing caused by the mixing. In the present invention, by using a specific one resin (i.e., single resin component) as main component resin, hazing is hardly caused by blending, so that the light transparency of the foam is enhanced.

Among the resins described above as the main component resin, any one of a polypropylene resin and a polyethylene resin is preferred and a polypropylene resin is more preferred. The foam made of polypropylene resin as main component resin has excellent heat resistance, is usable for a long period even when heated by a light source.

More specifically, in the case of using a polypropylene resin as main component resin, the polypropylene resin may be contained in an amount of 65 mass% or more, preferably 75 mass% or more, more preferably 85 mass% or more, most preferably 100 mass%, based on the total amount of the resin components.

Also, it is preferable that one specific resin of the polypropylene resins in amount of 65 mass% or more based on the total amount of the resin components be contained. For example, it is preferable that 65 mass% or more of a block polypropylene, or 65 mass% or more of a random polypropylene be contained, and in this case, the one specific resin in amount of preferably 75 mass% or more, more preferably 85 mass% or more, most preferably 100 mass%, is contained.

In like manner, in the case of using a polyethylene resin as main component resin, the polyethylene resin in amount of 65 mass% or more, preferably 75 mass% or more, still more preferably 85 mass% or more, based on the total amount of the resin components, may be contained.

Also, it is preferable that one specific resin of polyethylene resins in amount of 65 mass% or more based on the total amount of the resin components be contained. The specific resin is contained in amount of more preferably 75 mass% or more, still more preferably 85 mass% or more. For example, it is preferable that 65 mass% or more of LDPE be contained.

In the case of using a polypropylene resin as main component resin, a polypropylene resin alone may be used, or at least one selected from the group consisting of a polyethylene resin and an ethylene-vinyl acetate copolymer may be used in combination, in addition to a polypropylene resin as polyolefin resin. With a use of a one polypropylene resin, compatibilization with another polyolefin resin is not required, so that reduction in transparency resulting from mixing resins to each other is prevented. Also, with combination use of a polypropylene resin and at least one selected from the group consisting of an ethylene-vinyl acetate copolymer and a polyethylene resin improves compatibility, so that good transparency is maintained. Further, the crosslinking degree and the expansion ratio are easily controlled, so that the total light transmittance of the foam layer 30 can be easily controlled.

In this case, it is preferable that the content of a polypropylene resin be 65 to 95 mass%, and the content of at least one selected from the group consisting of a polyethylene resin and an ethylene-vinyl acetate copolymer be 5 to 35 mass%, based on the total amount of the resin components. Further, it is more preferable that the content of the former be 75 to 95 mass% and the content of the latter be 5 to 25 mass%, and it is still more preferable that the content of the former be 85 to 95 mass% and the content of the latter be 5 to 15 mass%.

Also, it is preferable that the resin for use in combination be any one of a polyethylene resin and an ethylene-vinyl acetate copolymer, and it is more preferable that the resin be an ethylene-vinyl acetate copolymer.

Also, in the case of using a polypropylene resin as main component resin, an elastomer may be further used as described below. In this case, the content of the elastomer is as described below.

On the other hand, in the case of using a polyethylene resin as main component resin, although single use of the polyethylene resin is preferred, at least one selected from the group consisting of a polypropylene resin and an ethylene-vinyl acetate copolymer may be used in combination with the polyethylene resin as polyolefin resin. In single use of a polyethylene resin, however, it is preferable that the polyethylene resin may be used in combination with an elastomer described below, and the content of the elastomer in that case is as follow.

The resin to compose the polyolefin resin foam may be made of a polyolefin resin alone or a mixture of a polyolefin resin and an elastomer. By containing an elastomer in the polyolefin resin composition, the crystallinity of the polyolefin resin can be reduced, so that the total light transmittance of the foam is improved. In other words, in the present invention, it is preferable to use an elastomer having a function as a so-called transparentizing agent.

Also, use of an elastomer improves the flexibility and the impact absorption of the foam.

As the elastomer, an elastomer having high compatibility with a polyolefin resin is preferred, and specific examples thereof include an ethylene-propylene-diene rubber (EPDM), an ethylene-propylene rubber (EPM) and a styrene rubber.

Further, examples of the elastomer include a thermoplastic elastomer. Examples of the thermoplastic elastomer include an olefin thermoplastic elastomer and a styrene thermoplastic elastomer.

As the elastomer, one of the components described above may be used alone or two or more may be used in combination. From the viewpoint of easy control of the total light transmittance of the foam in the range, a styrene rubber, an olefin thermoplastic elastomer, and a styrene thermoplastic elastomer are preferred, and in particular, a styrene rubber and a styrene thermoplastic elastomer are more preferred.

Examples of the styrene rubber include various types of polymers such as a random copolymer of styrene and a conjugated diene compound, and a hydrogenated product thereof. Specific examples include a styrene-butadiene copolymer (SBR) and a hydrogenated product thereof (HSBR).

Examples of the olefin thermoplastic elastomer include a blended type and a dynamically cross-linked type, and more specifically a thermoplastic elastomer composed of a hard segment made of a thermoplastic crystalline polyolefin such as polypropylene and polyethylene and a soft segment made of a completely vulcanized or partially vulcanized rubber. Examples of the soft segment component include a butyl rubber, a halobutyl rubber, EPDM, EPM, an acrylonitrile/butadiene rubber, NBR and a natural rubber, and it is preferable to use EPDM.

Further, examples of the olefin thermoplastic elastomer include a block copolymer type. Examples of the block copolymer type include one having a crystalline block and a soft segment block, and more specific examples include a crystalline olefin block-ethylene/butylene copolymer-crystalline olefin block copolymer (CEBC). In CEBC, it is preferable that the crystalline olefin block be a crystalline ethylene block, and examples of a commercial product of such CEBC include "DYNARON 6200P" manufactured by JSR Corporation.

Examples of the styrene thermoplastic elastomer include a block copolymer having a polymer or copolymer block of styrene and a polymer or copolymer block of a conjugated diene compound. Examples of the conjugated diene compound include isoprene and butadiene.

The styrene thermoplastic elastomer for use in the present invention may be hydrogenated or may not be hydrogenated. In the case of performing hydrogenation, the hydrogenation may be performed by a known method.

Examples of the styrene thermoplastic elastomer include a normal block copolymer such as a styrene-isoprene block copolymer, a styrene-isoprene-styrene block copolymer, a styrene-butadiene block copolymer, a styrene-butadienestyrene block copolymer, a styrene-ethylene/butylene-styrene block copolymer (SEBS), a styrene-ethylene/propylene-styrene block copolymer (SEPS), a styreneethylene/butylene block copolymer (SEB), a styrene-ethylene/propylene block copolymer (SEP), and a styrene-ethylene/butylene-crystalline olefin copolymer (SEBC).

As the styrene thermoplastic elastomer described above, a block copolymer is preferred, and in particular, SEBC is more preferred. By using such an elastomer in combination with a polyolefin resin, and further controlling the expansion ratio, the light transparency of the foam is able to be improved.

Examples of a commercial product of the styrene thermoplastic elastomer include "DYNARON 1320P" (product name, styrene content: 10 mass%) manufactured by JSR Corporation, "DYNARON 8600P" (product name, styrene content: 15 mass%), and "DYNARON 4600P" (product name, styrene content: 20 mass%).

In the case of using a polyolefin resin and an elastomer in combination as resin components in the foam constituting the foam layer 30, the content of the elastomer based on the total amount of the resin components is preferably 5 to 30 mass%, more preferably 8 to 22 mass%. With a content of the elastomer in the ranges, the light transparency of the foam may be further improved while maintaining the mechanical strength of the foam.

<Foaming agent>

The polyolefin resin foam constituting the foam layer 30 is obtained by foaming a polyolefin resin composition containing a polyolefin resin-containing resin, a foaming agent, etc. As the foaming agent, a thermally decomposable foaming agent is preferred.

As the thermally decomposable foaming agent, an organic foaming agent and an inorganic foaming agent are usable. Examples of the organic foaming agent include an azo compound such as azodicarbonamide, a metal salt of azodicarboxylic acid (barium azodicarboxylate, or the like), and azobisisobutyronitrile, a nitroso compound such as N,N'-dinitroso pentamethylene tetramine, a hydrazine derivative such as hydrazine carbonamide, 4,4'-oxybis(benzene sulfonyl hydrazide), and toluene sulfonyl hydrazide, and a semicarbazide compound such as toluene sulfonyl semicarbazide.

Examples of the inorganic foaming agent include ammonium carbonate, sodium carbonate, ammonium hydrogen carbonate, sodium hydrogen carbonate, ammonium nitrite, sodium borohydride, and anhydrous monosodium citrate.

In particular, an azo compound is preferred and azodicarbonamide is more preferred from the viewpoints of obtaining fine cells, economy and safety.

The thermally decomposable foaming agents may be used alone or in combination of two or more.

The content of the foaming agent in the polyolefin resin composition is preferably 1 to 30 parts by mass, more preferably 2 to 25 parts by mass, still more preferably 2 to 20 parts by mass, relative to 100 parts by mass of the polyolefin resin. With an amount of the foaming agent compounded of 1 part by mass or more, the resin composition is moderately foamed, so that moderate flexibility and impact absorption can be imparted to the foam. With an amount of foaming agent compounded of 30 parts by mass or less, the foam is prevented from being excessively foamed, so that good mechanical strength of the foam can be achieved.

<Additive>

The polyolefin resin composition may include a component such as a nucleating agent, a crosslinking aid, a decomposition temperature conditioner, and an antioxidant.

<Nucleating agent>

The nucleating agent is not particularly limited as long as it has an effect of increasing the rate of a crystal nucleation process. By adding a nucleating agent to a polyolefin resin such as polyethylene resin and polypropylene resin, the size of the crystals formed can be reduced, so that the transparency of the foam is improved.

Examples of the nucleating agent having an effect for enhancing the progress rate in a generation step of crystal nuclei include a material having an effect for facilitating the orientation of molecular chains through an adsorption step of the molecular chains of a polymer.

More specifically, examples include a high melting point polymer, an organic carboxylic acid or a metal salt thereof, aliphatic alcohols, dibenzylidene sorbitol or a derivative thereof, a partial metal salt of rosin acid, an amide compound, an inorganic fine particle, an organic phosphoric acid compound or a metal salt thereof, imides, quinacridones, quinones, an aromatic sulfonate or a metal salt thereof, saccharides, and a mixture thereof. These may be used alone or in combination of two or more.

In the case of using a nucleating agent, the content of the nucleating agent in the polyolefin resin composition is preferably 0.5 to 10 parts by mass, more preferably 1.5 to 8 parts by mass, and still more preferably 2 to 7 parts by mass, relative to 100 parts by mass of the polyolefin resin. With a content of the nucleating agent equal to or more than the lower limit, the transparency of the foam improves. On the other hand, with a content of the nucleating agent equal to or less than the upper limit, the transparency of the foam is able to be improved while suppressing the production cost.

The polyolefin resin composition constituting the foam layer 30 may contain both a nucleating agent and an elastomer, and preferably contains any one thereof. Due to having either one thereof, the composition enables the light transparency to be effectively improved.

As the crosslinking aid, a multifunctional monomer may be used. By adding a crosslinking aid to the polyolefin resin, the ionizing radiation dose irradiated in a step (2) described below is reduced to prevent cleavage and deterioration of resin molecules irradiated with the ionizing radiation.

Specific examples of the crosslinking aid include a compound having three functional groups in a molecule such as trimethylolpropane trimethacrylate, trimethylolpropane triacrylate, trimellitic acid triallyl ester, 1,2,4-benzenetricarboxylic acid triallyl ester, and triallyl isocyanurate, a compound having two functional groups in a molecule such as 1,6-hexanediol dimethacrylate, 1,9-nonanediol dimethacrylate, 1,10-decanediol dimethacrylate, and divinylbenzene, diallyl phthalate, diallyl terephthalate, diallyl isophthalate, ethylvinyl benzene, neopentyl glycol, dimethacrylate, lauryl methacrylate, and stearyl methacrylate.

These crosslinking aids may be used alone or in combination of two or more.

The amount of the crosslinking aid added is preferably 0.5 to 10 parts by mass, more preferably 1.0 to 8 parts by mass, still more preferably 1.5 to 5 parts by mass, relative to 100 parts by mass of the polyolefin resin. With an amount added of 0.5 parts by mass or more, the foam is able to stably obtain a desired crosslinking degree, and with an amount added of 10 parts by mass or less, the control of the crosslinking degree of the foam is easily performed.

In the polyolefin resin composition, a decomposition temperature conditioner may be compounded. The decomposition temperature conditioner can decrease the decomposition temperature of a thermally decomposable foaming agent or enhance and control the decomposition rate of the agent. Specific examples include zinc oxide, zinc stearate, and urea. In order to control the surface conditions of the foam, the decomposition temperature conditioner in an amount of, for example, 0.01 to 5 parts by mass relative to 100 parts by mass of the polyolefin resin is compounded.

In the polyolefin resin composition, an antioxidant may be compounded. Examples of the antioxidant include a phenol antioxidant such as 2,6-di-t-butyl-p-cresol and pentaerythritol tetrakis[3-(3,5-di-t-butyl-4-hydroxyphenyl)propionate], a sulfur antioxidant such as dilauryl thiodipropionate, a phosphorus antioxidant, and an amine antioxidant. The antioxidant in an amount of, for example, 0.01 to 5 parts by mass is compounded relative to 100 parts by mass of the polyolefin resin.

In the polyolefin resin composition, an additive other than those described above that is usually used in a foam such as a heat stabilizer, a colorant, a fire retardant, an antistatic agent, and a filler may be compounded.

[Production method of foam]

The production method of a polyolefin resin foam is not particularly limited, and the foam is produced by heating an expandable sheet made of a polyolefin resin composition containing at least a resin and a thermally decomposable foaming agent so as to foam the thermally decomposable foaming agent. More specifically, it is preferable that the production method include the following steps (1) to (3):

> Step (1): a step of forming an expandable sheet made of a polyolefin resin composition containing at least a resin and a thermally decomposable foaming agent;
> Step (2): a step of irradiating an ionizing radiation to the expandable sheet to cause crosslinking in the expandable sheet; and
> Step (3): a step of heating the cross-linked expandable sheet to foam the thermally decomposable foaming agent, so that a foam is obtained.

In the step (1), the method for forming an expandable sheet is not particularly limited, and forming may be performed by, for example, supplying a resin and an additive to an extruder, melt-kneading the mixture, and extruding a polyolefin resin composition from the extruder into a sheet form. Alternatively, the foam may be formed by pressing a polyolefin resin composition.

The forming temperature of the expandable sheet (i.e., temperature during extrusion or temperature during pressing) is preferably 50 to 250°C, more preferably 80 to 180°C.

In the step (2), as the method for cross-linking the polyolefin resin composition, a method for irradiating an ionizing radiation such as an electron beam, an $\alpha$ ray, a $\beta$ ray, and a $\gamma$ ray to the expandable sheet may be used. The dose of the ionizing radiation may be controlled such that the crosslinking degree of the resulting foam is in the desired range described above, being preferably 1 to 12 Mrad, more preferably 1.5 to 8 Mrad.

In the step (3), the heating temperature during foaming of the thermally decomposable foaming agent by heating the polyolefin resin composition may be equal to or more than the foaming temperature of the thermally decomposable foaming agent, being preferably 200 to 300°C, more preferably 220 to 280°C.

In the present production method, the foam may be stretched in either one or both of MD and TD. Stretching of the foam may be performed after obtaining the foam by foaming the expandable sheet, or may be performed during foaming the expandable sheet. In the case where the foam is stretched after obtaining the foam by foaming the expandable sheet, the foam may be subsequently stretched while maintaining the melting state during foaming without cooling of the foam, or the foam may be cooled and then reheated into a molten or softened state so as to be stretched. The foam is easily thinned by stretching. During stretching, the foam may be heated to, for example, 100 to 280°C, preferably 150 to 260°C. In the present invention, by stretching of the foam, the cell size of the foam increases along either one or both of MD and TD, so that the light transparency tends to be enhanced.

In the present production method, however, a foam may be obtained by a method other than the method described above, without limitation to the above. For example, instead of exposure to ionizing radiation, crosslinking may be performed by a method including compounding an organic peroxide in a polyolefin resin composition in advance and heating an expandable sheet to decompose the organic peroxide.

Also, in the production of a foam, the resulting foam may be sliced to obtain a desired thickness.

[Skin layer]

The skin layer 20 transmits the light from the light source 11. The thickness of the skin layer 20 is preferably 0.2 to 1.0 mm. With a thickness of the skin layer 20 of 1.0 mm or less, the skin layer 20 easily transmits light. With a thickness of the skin layer 20 of 0.2 mm or more, the inside including the foam layer 30, the printed layer and printed film layer 40, etc. is easily prevented from being seen through from the skin layer side. The thickness of the skin layer 20 is more preferably 0.2 to 0.8 mm, and still more preferably 0.2 to 0.7 mm.

The total light transmittance of the skin layer 20 is preferably 0.02 to 30%. With a total light transmittance of the skin layer 20 of 0.02% or more, the skin layer 20 transmits light easily. With a total light transmittance of the skin layer 20 of 30% or less, the inside including the foam layer 30, the printed layer and the printed film layer 40 provided on an as needed basis, etc. is easily prevented from being seen through from the skin layer side. The total light transmittance of the skin layer 20 is more preferably 0.05 to 25%, still more preferably 0.1 to 22%.

A skin layer 20 may contain a pigment such as carbon black, titanium dioxide, pearl particles, metal particles such as aluminum particles from the viewpoint of controlling the total light transmittance to a desired value. It is preferable that a skin layer 20 contain a resin sheet and a pigment described below. The content of the pigment in a skin layer 20 is preferably 0.01 to 3 mass%, more preferably 0.02 to 1 mass%, based on the total amount of skin layer 20.

The material to compose a skin layer 20 is not particularly limited, and examples thereof include a resin sheet such as a polypropylene sheet, a polyethylene sheet, an olefin thermoplastic elastomer (TPO) sheet, a polyvinyl chloride sheet, and a resin mixture sheet made of polyvinyl chloride and ABS resin, a fabric, knitting and nonwoven fabric made of natural fiber or synthetic fiber, and a leather made of artificial leather of synthetic leather.

Among those, a resin sheet is preferred from the viewpoint of easy control of the total light transmittance in a desired range. In particular, a polypropylene sheet and an olefin thermoplastic elastomer sheet are preferred, and an olefin thermoplastic elastomer sheet is more preferred.

In order to improve the design, an embossed pattern may be formed on the surface of a skin layer 20. Using a silicone stamper having irregularities transferred from real leather, stone, wood, etc., a lenticel pattern, a grain pattern, etc., may be drawn on the surface of a skin layer 20.

Also, from the viewpoint of preventing scratches, various types of coating may be applied to the surface of a skin layer.

The skin layer 20 may be made of soft member such as fabric, knitting, nonwoven fabric and resin sheet. In the case where the skin layer 20 made of soft member is used in combination of the foam layer, a soft and good texture can be imparted to the surface of the light-emitting display device. Alternatively, the skin layer 20 may be made of hard member such as a hard resin sheet. Even in the case of using a hard member, the presence of the foam layer allows the surface of the skin layer 20 to have a certain soft feel to the touch. Alternatively, a hard coat layer may be formed on the surface of the skin layer.

[Printed layer and printed film layer]

At least one layer 40 of the printed layer and the printed film layer allows figures and characters drawn on the at least one layer 40 of the printed layer and the printed film layer to be displayed by the light from the light source 11. The printed layer 40 may be formed, for example, by printing one side of the foam layer 30. Alternatively, the printed layer 40 may be formed by printing one side of the skin layer 20. Alternatively, the printed layer 40 may be formed by printing both one side of the foam layer 30 and one side of the skin layer 20.

The printed film layer 40 is one obtained by forming the printed layer 40 on a base material film i.e., a polyolefin film or a polyester film such as PET film. As a method for forming the printed layer 40, publicly known methods such as an inkjet method, a screen printing method, and a gravure printing method may be appropriately used. The thickness of the printed layer 40 is preferably 1 to 25 $\mu$m, more preferably 2 to 10 $\mu$m. The thickness of the printed film layer is preferably 4 to 50 $\mu$m, more preferably 12 to 25 $\mu$m.

It is preferable that the at least one layer 40 of a printed layer and a printed film layer be disposed between the skin layer 20 and the foam layer 30. Thereby, when the light source 11 emits no light, the at least one layer 40 of a printed layer and a printed film layer is prevented from being seen through from the outside.

(Production of light-emitting display device)

The light-emitting display device in an embodiment of the present invention is able to be produced, for example, by laminating a skin layer 20, a foam layer 30, at least one layer 40 of a printed layer and a printed film layer, and a base material 10 having a light source 11 mounted thereon. The foam layer 30 and the skin layer 20 for use may have a printed layer 40 formed thereon. In that case, the foam layer 30 with the printed layer 40 formed thereon may be laminated on the skin layer 20, or the skin layer 20 with the printed layer 40 formed thereon may be laminated on the foam layer 30. For lamination, a thermal lamination method may be used, or the layers may be bonded together with an adhesive. Alternatively, a hot melt method, a highfrequency welding method, etc. may be used. Note that even in the case of bonding the layers with an adhesive, pressure application is required to embed at least a portion of the light source in the foam layer.

(Use of light-emitting display device)

Examples of vehicle interior members with use of the light-emitting display device in an embodiment of the present invention include ceiling panels, door panels, instrument panels and trim. By using the light-emitting display device in an embodiment of the present invention as these vehicle interior members, the vehicle interior member can emit light as ambient light, or the vehicle interior member can display information of switches or the like. Alternatively, the light-emitting display device in an embodiment of the present invention may be used for ceilings, walls, floors, doors, windows, partitions, etc. of a building.

<Modified examples>

The light-emitting display device in an embodiment of the present invention may be modified as follows.

[Modified example 1]

The light-emitting display device in an embodiment of the present invention includes a base material, a skin layer, a foam layer, and at least one layer of a printed layer and a printed film layer. However, the light-emitting display device may not include a skin layer as long as it includes a base material having a light source mounted thereon and a foam layer that transmits and diffuses the light from the light source and has at least a portion of the light source embedded therein. Further, the light-emitting display device may not include at least one layer of the printed layer and the printed film layer. Furthermore, the light-emitting display device may not include the skin layer and at least one layer of the printed layer and the printed film layer. In these cases as well, the light-emitting display device can effectively utilize light from a light source with a simplified component configuration.

[Modified example 2]

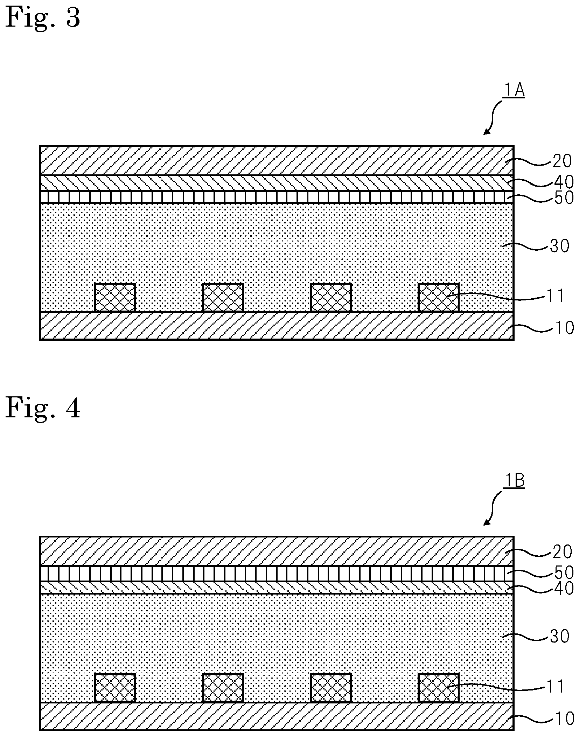

As shown in Fig. 3, a light-emitting display device 1A may further include a transparent conductive layer 50 provided between a skin layer 20 and a base material 10. Thereby, to the light-emitting display device 1A, for example, a function as switch or the like can be added in addition to a function of emitting light and a function of displaying information. For example, an icon displayed by the light-emitting display device 1A may be used as a switch.

The transparent conductive layer 50 is not particularly limited, and any conventionally known transparent electrode material may be used without particular limitation. Examples thereof include an indium tin oxide (ITO) conductive film, a tin oxide conductive film, a zinc oxide conductive film, and a polymer conductive film. Alternatively, the transparent conductive layer 50 may be a metal mesh-type transparent conductive film made of conductive metal such as copper (Cu) and silver (Ag). Alternatively, a non-metallic conductive layer made of carbon nanotubes may be used. Further, the transparent conductive layer 50 may be a layer having a wiring pattern made of conductive metal such as copper (Cu) and silver (Ag), or conductive paste containing conductive metal powder or carbon powder. Light from the light source can pass through between lines of the wiring pattern. It is preferable that the metal mesh and the wiring pattern have lines that are thin enough not to impede transmission of light from the light source.

The transparent conductive layer 50 usually includes an electrode material provided on a base material (base material for conductive layer), though may be composed of a single electrode material. A flexible substrate is preferred as the base material for the conductive layer. Details of the flexible substrate are as described above. Use of the flexible substrate allows the light-emitting display device 1 to easily follow the curved surface of a vehicle, building furniture, etc., and the transparent conductive layer 50 to be easily formed into a three-dimensional shape.

The transparent conductive layer 50 may be used, for example, as a conductive layer that constitutes a touch sensor. A touch sensor including the transparent conductive layer 50 allows a switch function to be imparted to the light-emitting display device 1A. The touch sensor is a sensor that detects a touch input when a finger, a touch pen, or another object approaches or comes into contact with the skin layer 20, and includes the transparent conductive layer 50. The touch sensor detects a touch input through electrical changes in capacitance, current, voltage, etc., that occur in the conductive layer when a finger, a touch pen, or another object approaches or comes into contact with the skin layer 20.

The type of touch sensor is not particularly limited, and examples thereof may include a capacitance type and a resistive film type. Alternatively, the touch sensor may be a gesture sensor or the like.

In the case of a touch sensor including the transparent conductive layer 50, the transparent conductive layer 50 is preferably disposed near the skin layer 20, specifically between the foam layer 30 and the skin layer 20. More specifically, like the light-emitting display device 1A as shown in Fig. 3, the transparent conductive layer 50 may be disposed between the at least one layer 40 of a printed layer and a printed film layer, and the foam layer 30, or like the light-emitting display device 1B as shown in Fig. 4, the transparent conductive layer 50 may be disposed between the at least one layer 40 of a printed layer and a printed film layer, and the skin layer 20. In the case where the at least one layer 40 of a printed layer and a printed film layer is the printed layer in Fig. 3 and Fig. 4, the printed layer may be formed by printing one side of the transparent conductive layer 50, or may be formed by printing the foam layer 30 or the skin layer 20 as described above. A control device that controls the touch sensor may be mounted, for example, on the base material 10. Note that in Modification example 2 as well, the skin layer 20 may be omitted, or the at least one layer 40 of a printed layer and a printed film layer may be omitted appropriately.

[Modification Example 3]

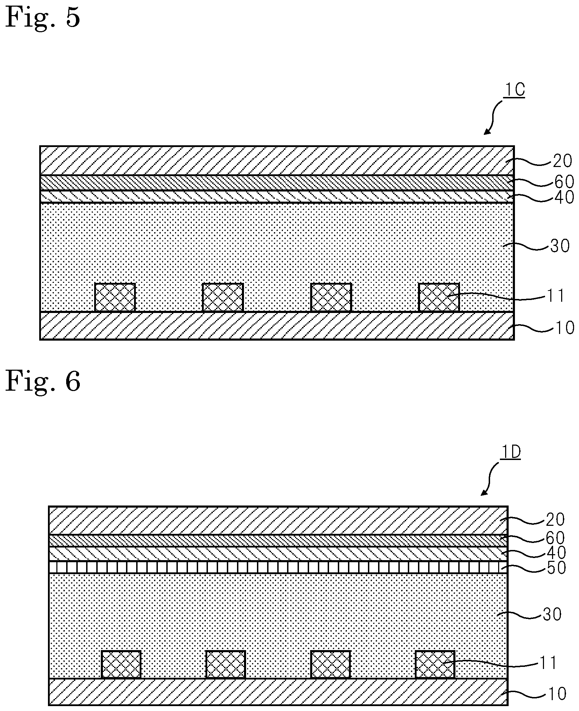

As shown in Fig. 5, a light-emitting display device 1C may further include a light control layer 60 between a skin layer 20 and a base material 10. Thereby, when the light source 11 emits no light, the at least one layer 40 of a printed layer and a printed film layer, the light source 11, the base material 10, etc. can be further prevented from being seen through from the outside. Incidentally, when the light source 11 emits no light, by reducing the light transmittance of the skin layer 20, the light source 11, the base material 10, the at least one layer of a printed layer and a printed film layer etc. can be prevented from being seen through from the outside. However, in this case, in order to make a luminous display on the surface of the skin layer 20 having low light transmittance with light from the light source 11, the light generated by the light source 11 is required to have high intensity. As a result, the power consumption of the light-emitting display device considerably increases. In particular, in the case of using a light-emitting display device as an interior material of an electric vehicle, the increase in power consumption becomes a serious problem. The light-emitting display device 1C further including a light control layer 60 between the skin layer 20 and the base material 10 can further prevent the at least one layer 40 of a printed layer and a printed film layer, the light source 11, the base material 10, etc. from being seen through from the outside, while suppressing an increase in power consumption. Note that the light control layer 60 is controlled to have an increased light transmittance when the light source 11 is turned on, and to have a decreased light transmittance when the light source 11 is turned off. For example, the control may be performed as follows. When the light source 11 is turned on, power is supplied to the light control layer 60, so that the light transmittance of the light control layer 60 increases. When the light source 11 is turned off, no power is supplied to the light control layer 60, so that the light transmittance of the light control layer 60 decreases. The control device that controls the light control of the light control layer 60 may be mounted, for example, on the base material 10. In Modification example 3 as well, the skin layer 20 may be omitted, and the at least one layer 40 of a printed layer and a printed film layer may be appropriately omitted.

From the viewpoint of further preventing the at least one layer 40 of a printed layer and a printed film layer from being seen through from the outside, it is preferable that as in the light-emitting display device 1C shown in Fig. 5, the light control layer 60 be disposed between the at least one layer 40 of a printed layer and a printed film layer, and the skin layer 20. In the case where although the at least one layer 40 of a printed layer and a printed film layer may be seen through from the outside, it is desired that the light source 11 and the base material 10 are not seen through from the outside, the light control layer 60 may be disposed between the at least one layer 40 of a printed layer and a printed film layer, and the foam layer 30. Further, as shown in Fig. 6, the light-emitting display device 1D may include a transparent conductive layer 50 in addition to the light control layer 60. The position of the transparent conductive layer 50 is not particularly limited, and for example, may be provided between the at least one layer 40 of a printed layer and a printed film layer, and the light control layer 60, may be disposed outside of the light control layer 60, or may be provided between the light control layer 60 and the skin layer 20. However, as in the light-emitting display device 1D shown in Fig. 6, the transparent conductive layer 50 is preferably provided closer to the base material 10 than the light control layer 60. Specifically, it is more preferably disposed between the at least one layer 40 of a printed layer and a printed film layer, and the foam layer 30.

The light control layer 60 changes the visible light transmittance by, for example, switching between applying and not applying a voltage between the conductive layers of two resin films. The light control layer 60 is preferably composed of a liquid crystal layer such as polymer dispersed liquid crystal (PDLC). Alternatively, the light control layer 60 may be an SPD layer including a resin matrix and a light control suspension dispersed in the resin matrix, or may be an electrochromic material layer. Alternatively, the light control layer 60 may be an electrophoretic layer that includes electrophoretic particles and a dispersant that disperses the electrophoretic particles.

Alternatively, the light-emitting display device may include an optical switching layer such as a half mirror instead of the light control layer 60. Examples of the optical switching layer include a transparent base material such as a resin film having a surface with a metal layer having a high reflectance. When the light source is not turned on, the outside of the light-emitting display device is brighter than the inside of the light-emitting display device, so that the light source 11, the base material 10, and the at least one layer of a printed layer and a printed film layer are hardly seen through from the outside, due to the presence of the optical switching layer. In contrast, when the light source is turned on, the at least one layer of a printed layer and a printed film layer is illuminated by the light-emitting display device, and is clearly seen from the outside despite of the presence of the optical switching layer.

[Modification example 4]

As shown in Fig. 7, a light-emitting display device 1E may further include a transparent heater layer 70. The transparent heater layer 70 is a thin film of transparent conductive material formed on the surface of a base material. A current passing through the thin film of transparent conductive material allows the thin film of transparent conductive material to generates heat, so that the transparent heater layer 70 generates heat. Since the light source 11 emits warm-colored light and the transparent heater layer 70 generates heat, the light-emitting display device 1E is felt warm not only tactually but also visually. In order to warm the skin layer 20, the transparent heater layer 70 is preferably disposed near the skin layer 20. For example, as in the light-emitting display device 1E shown in Fig. 7, a transparent heater layer 70 may be provided between the skin layer 20 and the foam layer 30. Moreover, since the light-emitting display device 1F is felt tactilely warm, a transparent conductive layer 50 may be included therein in addition to the transparent heater layer 70, as shown in Fig 8. For example, as in a light-emitting display device 1F shown in Fig. 8, the transparent conductive layer 50 may be provided between the skin layer 20 and the transparent heater layer 70. However, the position of the transparent heater layer 70 is not limited to between the skin layer 20 and the foam layer 30, or between the transparent conductive layer 50 and the foam layer 30. The transparent heater layer 70 may be provided at other positions, and for example, it may be provided on a side of the base material 10 opposite to the side on which the foam layer 30 is provided. Incidentally, a control device that controls the transparent heater layer 70 may be mounted on the base material 10. Alternatively, the skin layer 20 may be omitted in Modification example 4 as well.

[Modification example 5]

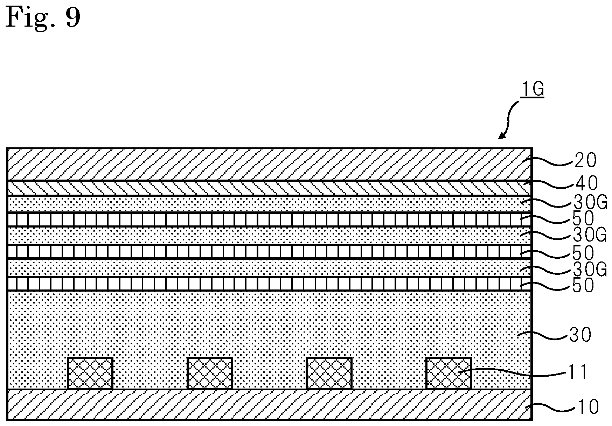

As shown in Fig. 9, a light-emitting display device 1G may further include a plurality of transparent conductive layers 50 provided between a skin layer 20 and a base material 10. In that case, a foam layer 30G preferably lies between the neighboring transparent conductive layers 50. Thereby, the light-emitting display device 1G may not only detect whether or not the light-emitting display device G is touched, but also detect the pressing amount, pressing speed, etc. when the light-emitting display device G is touched. As a result, it is possible to determine whether an operator has touched the light-emitting display device G by mistake or intentionally, so that malfunctions of the light-emitting display device G may be suppressed. As the transparent conductive layer 50, the same one as in Modification example 2 may be used. Incidentally, the skin layer 20 may be omitted in Modification example 5 as well.

[Other modification examples]

Although the touch sensors including a transparent conductive layer and the like have been shown in the Modification example 2, etc., other sensors may be provided instead of a transparent conductive layer. For example, an acceleration sensor, a push-in sensor, etc. may be used. These may be provided with a switch function similar to a touch sensor.

Alternatively, a non-contact type gesture sensor, a contact type motion sensor, or the like may be used as a sensor.

The light-emitting display device in an embodiment of the present invention and the modification examples thereof are merely examples of the light-emitting display device of the present invention. Accordingly, the light-emitting display device of the present invention is not limited to the light-emitting display device in an embodiment of the present invention and the modification examples thereof.

Examples

The present invention is more specifically described with reference to Examples, though the present invention is not limited thereto.

The evaluation method is as follows.

<Expansion ratio>

The expansion ratio was calculated by determining the density (apparent density) of a foam layer and then calculating the reciprocal of the density. The apparent density was measured in accordance with JIS K7222: 2005.

<Gel fraction (crosslinking degree)>

About 100 mg of a test piece was collected from a foam sheet, and the weight A (mg) of the test piece was precisely measured. Subsequently, the test piece was immersed in 30 $cm^3$ of xylene at 120°C and left standing for 24 hours. Filtration was then performed with a 200-mesh wire mesh to collect an insoluble matter on the wire mesh. The insoluble matter was vacuum-dried and subjected to accurate measurement of the weight B (mg). From the measurement value, the crosslinking degree (mass%) was calculated based on the following equation.

$$\text{Crosslinking degree (mass\%)} = (B/A) \times 100$$

<Total light transmittance>

The total light transmittance was measured in accordance with ASTM D1003 with a haze meter.

<Visual recognizability>

An LED was turned on and off to evaluate a light-emitting display device based on the following criteria.

Good: When the LED was turned on, characters "SEKISUI" were displayed, while when the LED was turned off, characters "SEKISUI" were not visible.

Poor: When the LED was turned on, characters "SEKISUI" were not clearly visible, or when the LED was turned off, characters "SEKISUI" were clearly visible.

<Raw material used for foam layer>

The materials that were used in Examples or Comparative Examples are as described below.

[Polyolefin resin]

Polypropylene resin (PP): "NOBLEN AD571" manufactured by Sumitomo Chemical Co., Ltd. (density: 0.900 g/cm$^3$)
Polyethylene resin (LLDPE, linear low density polyethylene): "NIPOLON-Z ZF231B" manufactured by Tosoh Corporation (density: 0.917 g/cm$^3$)

[Foaming agent]

Azodicarbonamide: "AC#R" (azodicarbonamide) manufactured by Eiwa Chemical Ind. Co., Ltd.
Crosslinking aid: "LIGHT ESTER 1.9-ND" (1,9-nonanediol dimethacrylate) manufactured by Kyoeisha Chemical Co., Ltd.
Antioxidant: "IRGANOX 1010" manufactured by BASF Japan.

<Skin layer>

The skin layer that used in Examples and Comparative Examples contains a pigment master batch (PEX 99901 manufactured by Tokyo Ink Mfg. Co., Ltd.) containing 40 wt% of a pigment (carbon black), and an olefin thermoplastic elastomer (TPO). The amount of the pigment master batch compounded and the content of the pigment were adjusted as shown in Table 1. The content of the pigment shown in Table 1 is a value based on the total amount of the skin layer.

<Printed film layer>

Using an inkjet printer, characters "SEKISUI" were printed on a PET film, so that a printed film layer was prepared.

(Example 1)

An expandable sheet was obtained by melt-kneading 85 parts by mass of a polypropylene resin (PP), 15 parts by mass of polyethylene resin (LLDPE), 6 parts by mass of a foaming agent, 3 parts by mass of a crosslinking aid and 0.5 parts by mass of an antioxidant, and then pressing the mixture. Both sides of the resulting expandable sheet were irradiated with 2 Mrad of electron beams at an acceleration voltage of 800 keV, so that the expandable sheet was cross-linked. Subsequently, the cross-linked expandable sheet was heated at 250°C to cause foaming, so that a foam layer having an expansion ratio of 13 and a thickness of 0.6 mm was obtained.
A skin material, a printed film layer, a resulting foam layer, and a substrate on which an LED was mounted were laminated through an adhesive sheet with a thickness of 0.03 mm (manufactured by Sekisui Chemical Co., Ltd., "3803H"), so that a light-emitting display device was prepared. The light-emitting display device was then pressurized until the LED was embedded in the foam layer.
Each evaluation was performed on the resulting laminated body, and the results are shown in Table 1.

Table 1

| | | | Example 1 |
|---|---|---|---|
| Expandable resin composition (part by mass) | Polyolefin resin | PP | 85 |
| | | LLDPE | 15 |
| | Foaming agent | Azodicarbonamide | 6 |
| | Crosslinking aid | | 3 |
| | Antioxidant | | 0.5 |

(continued)

|  |  |  | Example 1 |
|---|---|---|---|
|  | Skin layer | Thickness (mm) | 0.4 |
|  |  | Total light transmittance (%) | 6 |
|  |  | Amount of pigment master batch compounded (mass%) | 0.2 |
|  |  | Content of pigment (mass%) | 0.08 |
| Light-emitting display device |  | Material | TPO |
|  | Foam layer | Thickness (mm) | 0.6 |
|  |  | Total light transmittance (%) | 37 |
|  |  | Expansion ratio (times) | 13 |
|  |  | Degree of crosslinking (mass%) | 30 |
|  |  | Material | PP |
|  | Evaluation | Visual recognizability | Good |

The light-emitting display device of Example 1 includes a substrate on which an LED is mounted, a skin layer that transmits light from the light source, a foam layer that transmits and diffuses the light from the light source, and embeds at least a portion of the light source therein, and a printed film layer. Therefore, the light-emitting display device in Example 1 allows the characters on the printed film layer to be displayed when the LED is turned on though having no light guide member, and prevents the characters on the printed film layer from being seen through from the outside when the LED is turned off.

Reference Signs List

1, 1A to 1G: LIGHT-EMITTING DISPLAY DEVICE
10: BASE MATERIAL
11: LIGHT SOURCE
20: SKIN LAYER
30, 30G: FOAM LAYER
40: AT LEAST ONE LAYER OF PRINTED LAYER AND PRINTED FILM LAYER
50: TRANSPARENT CONDUCTIVE LAYER
60: LIGHT CONTROL LAYER
70: TRANSPARENT HEATER LAYER

**Claims**

1. A light-emitting display device comprising:

   a base material having a light source mounted thereon; and
   a foam layer that transmits and diffuses light from the light source and has at least a portion of the light source embedded therein.

2. The light-emitting display device according to claim 1, further comprising a skin layer that transmits light from the light source,
   wherein the foam layer is provided between the skin layer and the base material.

3. The light-emitting display device according to claim 2, further comprising at least one layer of a printed layer and a printed film layer, provided between the skin layer and the foam layer.

4. The light-emitting display device according to claim 3, wherein the printed layer is formed by printing the surface of at least one layer of the foam layer and the skin layer.

5. The light-emitting display device according to any one of claims 2 to 4, further comprising a transparent conductive layer provided between the skin layer and the base material.

6. The light-emitting display device according to any one of claims 2 to 5, further comprising a light control layer provided between the skin layer and the base material.

7. The light-emitting display device according to any one of claims 1 to 6, wherein the base material is a flexible substrate.

8. The light-emitting display device according to any one of claims 1 to 7, wherein the base material and the foam layer are formed into a three-dimensional shape.

Fig. 1

# Fig. 2

(a)

(b)

Fig. 3

Fig. 4

Fig. 5

Fig. 6

Fig. 7

1E

20
70
30
11
10

Fig. 8

1F

20
50
70
30
11
10

Fig. 9

## INTERNATIONAL SEARCH REPORT

| International application No. |
| --- |
| **PCT/JP2023/012186** |

### A.    CLASSIFICATION OF SUBJECT MATTER

*G09F 13/04*(2006.01)i; *H10K 59/00*(2023.01)i

FI:    G09F13/04 D; H10K59/00

According to International Patent Classification (IPC) or to both national classification and IPC

### B.    FIELDS SEARCHED

Minimum documentation searched (classification system followed by classification symbols)

G09F13/04; H10K59/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
| --- | --- | --- |
| X | JP 2009-289701 A (SHARP KABUSHIKI KAISHA) 10 December 2009 (2009-12-10) | 1, 8 |
| | paragraphs [0014]-[0073], fig. 1 | |
| Y | paragraphs [0014]-[0073], fig. 1 | 2-7 |
| Y | JP 2015-4920 A (HIRAOKA & CO., LTD.) 08 January 2015 (2015-01-08) | 2-7 |
| | paragraphs [0023]-[0044], fig. 1 | |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **01 May 2023** | **23 May 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2023/012186**

| Patent document cited in search report | | | Publication date (day/month/year) | Patent family member(s) | Publication date (day/month/year) |
|---|---|---|---|---|---|
| JP | 2009-289701 | A | 10 December 2009 | (Family: none) | |
| JP | 2015-4920 | A | 08 January 2015 | (Family: none) | |

Form PCT/ISA/210 (patent family annex) (January 2015)

**REFERENCES CITED IN THE DESCRIPTION**

**Patent documents cited in the description**

- JP 2019188919 A